# EUROPÄISCHE PATENTSCHRIFT

(11) **EP 0 494 879 B1**
(45) Veröffentlichungstag und Bekanntmachung des Hinweises auf die Patenterteilung: **29.06.1994**
(21) Anmeldenummer: 90913162.5
(22) Anmeldetag: 07.09.1990
(51) Int. Cl.: G11B 7/08

(54) **SPULENANORDNUNG FÜR EINEN FOKUS- ODER SPURREGELKREIS**
COIL ARRANGEMENT FOR A FOCUSSING OR TRACK CONTROL CIRCUIT
AGENCEMENT DE BOBINES POUR UN CIRCUIT DE REGLAGE DE FOYER OU DE PISTE

(30) Priorität: 02.10.1989 DE 3932860
(43) Veröffentlichungstag der Anmeldung: 22.07.1992
(73) Patentinhaber: Deutsche Thomson-Brandt GmbH, 78003 Villingen-Schwenningen (DE)
(72) Erfinder: SUZUKI, Tsuneo, D-7733 Mönchweiler (DE)
(86) Internationale Anmeldenummer: EP9001515
(87) Internationale Veröffentlichungsnummer: WO9105337

(56) Entgegenhaltungen:
- EP-A- 0 252 651
- Patent abstract of Japan vol. 8,no.53 (P-283) 30 Juni 1984 & JP-A-59 040329
- Patent abstracts of Japan vol. 10, no. 53 (P-433)(2210) 4 März 1986 & JP-A-60 197940

## Beschreibung

Die Erfindung betrifft eine Spulenanordnung für einen Fokus- oder Spurregelkreis, bei der die Spulen auf einer biegsamen Leiterfolie als gedruckte Schaltung angeordnet und als Stellglieder für den Fokus- oder Spurregelkreis vorgesehen sind.

Spulen mit einem Durchmesser von etwa nur 4 mm, die aus sehr dünnem Draht mit einem Durchmesser von etwa 0,08 bis 0,1 mm gefertigt sind, dienen z.B. als Stellglieder in den Servokreisen eines CD-Spielers.

Ein CD-Spieler ist mit zwei Servokreisen ausgerüstet, dem Fokusregelkreis und dem Spurregelkreis. Der Fokusregelkreis fokussiert mittels einer Objektivlinse einen Lichtstrahl auf einen Aufzeichnungsträger, die sogenannte CD. Der Spurregelkreis bewirkt, daß der Lichtstrahl mittels der Objektivlinse genau auf den Datenspuren des Aufzeichnungsträgers geführt wird.

Die Objektivlinse kann z.B. in einem quaderförmigen Gehäuse sitzen. Auf zwei gegenüberliegenden Seiten des Gehäuses ist je eine Fokusspule für den Fokusregelkreis angeordnet, deren Achse parallel zur optischen Achse der Objektivlinse verläuft. Auf der Außenseite jeder Fokusspule sind je zwei Spurspulen für den Spurregelkreis angeordnet, deren Achsen senkrecht zu den Achsen der Fokusspulen stehen und in radialer Richtung bezüglich der CD verlaufen. In den Innenraum der Fokusspulen ragt je ein Schenkel eines U-förmigen Eisenjochs oder eines Hufeisenmagneten, so daß die Spurspulen vollständig zwischen den beiden Schenkeln liegen.

Das Gehäuse mit der Objektivlinse ist mittels einer Vorrichtung so an einer Halterung befestigt, daß es in Richtung der optischen Achse und in radialer Richtung bezüglich der CD bewegbar ist. Mittels der Fokusspulen, den Stellgliedern des Fokusregelkreises, läßt sich daher die Objektivlinse senkrecht zum Aufzeichnungsträger bewegen, um den Lichtstrahl auf ihn fokussieren zu können.

Mittels der Spurspulen, den Stellgliedern des Spurregelkreises, läßt sich das Gehäuse mit der Objektivlinse dagegen in radialer Richtung verschieben, um den Lichtstrahl entlang den Datenspuren des plattenförmigen Aufzeichnungsträgers führen zu können. Damit die Spurspulen aber nicht zu lang werden, sind auf jeder Fokusspule zwei Spurspulen nebeneinander angeordnet.

Es ist zwar möglich, die beiden Spurspulen, die einen Durchmesser von etwa 3 mm und eine Länge von ungefähr 0,4 mm aufweisen, aus sehr dünnem Draht zu wickeln, jedoch beherrschen diese Technik nur sehr wenige Hersteller. Werden dagegen zwei getrennte Spurspulen gewickelt, so müssen ihre Drahtenden miteinander verlötet werden. Weil der Draht für die Spurspulen aber einen Durchmesser von nur 0,08 bis 0,1 mm hat, sind diese Lötarbeiten nicht leicht auszuführen.

Aus der EP-A 0 252 651 ist es bekannt, die Spulen des Spurregelkreises um Bewegen der Objektivlinse als Leiterbahnen auf einer biegsamen Folie vorzusehen. Es sind zwei Folien mit Spulen übereinander gelegt. Die eine Folie dient zum Bewegen der Objektivlinse, während mittels der anderen Folie die Bewegungen der Objektivlinse gemessen werden. Die andere Folie ist deshalb als Meßwertaufnehmer vorgesehen.

In der JP-A-59 040329 ist eine optische Abtastvorrichtung bekannt, bei der auf einer biegsamen Folie, die auf den Mantel eines Zylinders geklebt ist, mehrere Spulen geklebt sind.

In der JP-A-60 197940 ist eine Leiterfolie für eine optische Abtastvorrichtung folgenden Aufbaus offenbart.

Auf einer biegsamen Leiterfolie in Form eines auf den Kopf gestellten T ist auf dem senkrechten Balken die Fokusspule angeordnet, während in jeder Hälfte des waagerechten Balkens eine Spurspule liegt. Die Folie wird an einer Seite eines quaderförmigen Gehäuses befestigt, das die Objektivlinse trägt. Der überstehende Teil des Längsbalkens und die überstehenden Teile der Querbalken werden rechtwinklig umgebogen, damit sie auf den Seiten des Gehäuses fest anliegen.

Es ist nun Aufgabe der Erfindung, eine Spulenanordnung für einen Fokus- oder Spurregelkreis, bei der die Spulen auf einer biegsamen Leiterfolie als gedruckte Schaltung angeordnet und als Stellglieder für den Fokus- oder Spurregelkreis vorgesehen sind, so zu gestalten, daß sie mit einfachen technischen Mitteln leicht herstellbar ist, um die Produktionskosten zu senken.

Die Erfindung löst diese Aufgabe dadurch, daß die Leiterfolie H-förmig gestaltet ist, daß in den Längsbalken des H Spulen gedruckt sind, daß im Querbalken eine Blende, Lötstützpunkte und Leiterbahnen vorgesehen sind, daß der Querbalken auf der Ober- oder Unterseite eines quaderförmigen Gehäuses, in dem eine Objektivlinse sitzt, angeordnet ist und daß die Längsbalken des H um die Seiten des Gehäuses gebogen sind.

Es zeigen
- Figur 1: ein Gehäuse mit einer Objektivlinse, zwei Fokus- und und vier Spurspulen und zwei U-förmigen Eisenjochen für einen CD-Spieler in Draufsicht
- Figur 2: das Gehäuse aus Figur 1 in Seitenansicht
- Figur 3: die Erfindung gemäß Anspruch 1

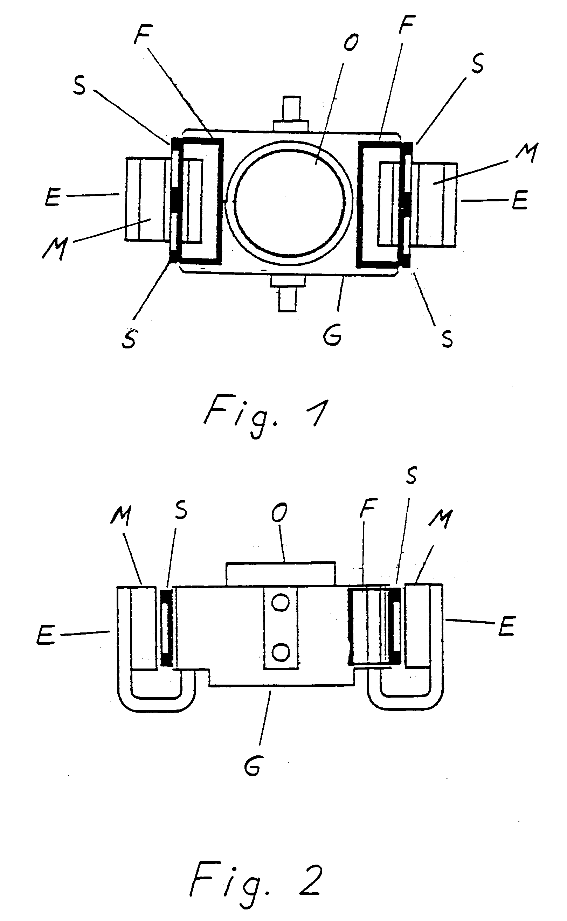

Figur 1 zeigt einen Teil einer optischen Abtastvorrichtung eines CD-Spielers. An zwei gegenüberliegenden Seiten eines Gehäuses G, in dessen Mitte eine Objektivlinse O sitzt, ist je eine Fokusspule F befestigt, deren Achse parallel zur optischen Achse der Objektivlinse O verläuft. An der Außenseite jeder Fokusspule F sind je zwei Spurspulen S angeordnet, deren Achsen senkrecht zur optischen Achse der Objektivlinse O verlaufen. In den Innenraum der Fokusspulen F ragt ein Schenkel eines Einsenjochs E, so daß die Spurspulen S zwischen den beiden Schenkeln des Eisenjochs E liegen. An einem Schenkel jedes Einsenjochs E kann ein Magnet M angeordnet sein.

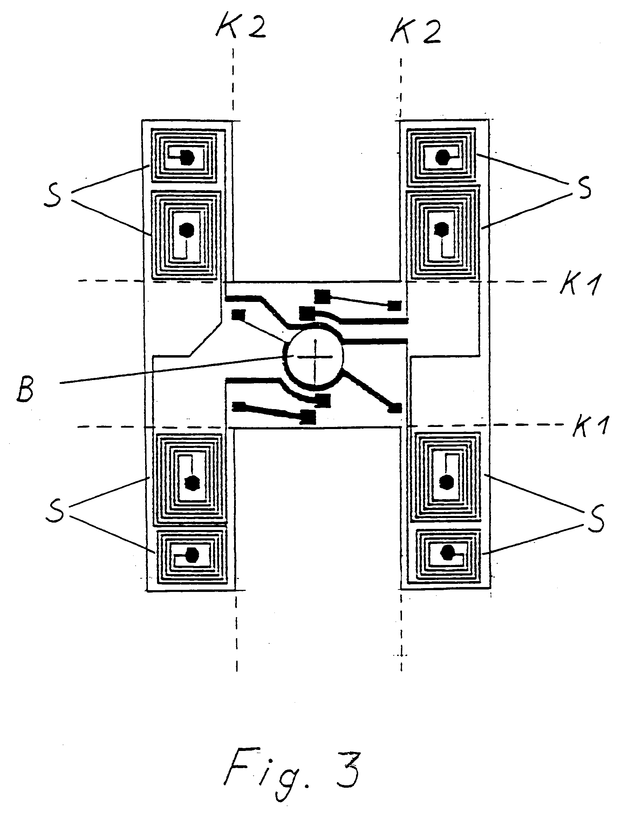

An Hand der Figur 3 wird die Erfindung nun beschrieben und erläutert.

Die Figur 3 zeigt eine Leiterfolie, die H-förmig gestaltet ist. In den Längsbalken des H sind vier Spulen S angeordnet. Im Querbalken liegen Lötstützpunkte und Leiterbahnen für die Stromanschlüsse. In der Mitte des Querbalkens ist eine Blende B für den Lichtstrahl vorgesehen. Die H-förmige Folie mit den gedruckten Spulen wird auf die obere oder untere Seite des Gehäuses G geklebt. Wegen der Blende B kann der Lichtstrahl ungehindert durch die Objektivlinse O auf den Aufzeichnungsträger strahlen.

Die Längsbalken der H-förmigen Folie werden zunächst um die Knickkanten K1 an die einen beiden sich gegenüberliegenden Seiten des Gehäuses G gebogen. Anschließend werden die überstehenden Schenkel der Längsbalken um die Knickkanten K2 an die anderen beiden sich gegenüberliegenden Seiten des Gehäuses G gebogen. Bis auf die Ober- oder Unterseite ist das Gehäuse G nun vollständig in Folie gepackt. Es liegen jeweils zwei Spulen übereinander. Die Längsbalken können z.B. länger ausgeführt und mit mehr als vier Spulen bedruckt sein. Um die Feldstärke zu erhöhen, werden sie so zusammengefaltet, daß Faltkanten jeweils zwischen zwei Spulen liegen. In jedem Faltblatt liegt dann eine Spule.

Die Erfindung ist für mehrere miteinander verbundene Spulen geringer Abmessungen geeignet. Insbesondere ist sie für die Spulen des Spurregelkreises einer optischen Abtastvorrichtung geeignet, wie sie in einem CD-Spieler, Videoplattenspieler, DRAW-Disc-Spieler oder einem magneto-optischen Aufzeichnungs- und/oder Wiedergabegerät eingebaut ist.

## Patentansprüche

1. Spulenanordnung für einen Fokus- oder Spurregelkreis, bei der die Spulen (S) auf einer biegsamen Leiterfolie als gedruckte Schaltung angeordnet sind und als Stellglieder für den Fokus- oder Spurregelkreis vorgesehen sind, **dadurch gekennzeichnet,** daß die Leiterfolie H-förmig gestaltet ist, daß in den Längsbalken des H Spulen (S) gedruckt sind, daß im Querbalken eine Blende (B), Lötstützpunkte und Leiterbahnen vorgesehen sind, daß der Querbalken auf der Ober- oder Unterseite eines quaderförmigen Gehäuses (G), in dem eine Objektivlinse (O) sitzt, angeordnet ist und daß die Längsbalken des H um die Seiten des Gehäuses (G) gebogen sind.

2. Spulenanordnung nach Anspruch 1, **dadurch gekennzeichnet,** daß in jedem Längsbalken mehrere Spulen nebeneinander liegen, daß jeder Längsbalken jeweils nach m Spulen gefaltet ist, wobei m eine ganze Zahl ist, so daß mehrere Spulen hintereinander liegen.

3. Spulenanordnung nach Anspruch 1 oder 2, **dadurch gekennzeichnet,** daß die Leiterfolie beidseitig mit Spulen bedruckt ist.

## Claims

1. A coil arrangement for a focus or track control circuit, in which the coils (S) are arranged as a printed circuit on a flexible conductor foil and are provided as adjustment members for the focus or track control circuit, characterised in that the conductor foil is constructed in an H-shape, that the coils (S) are printed in the longitudinal arms of the H, that in the transverse arm there are provided an aperture (B), soldering terminals and conductive tracks, that the transverse arm is arranged on the upper or lower face of a rectangular housing (G) in which there is located an objective lens (O), and that the longitudinal arms of the H are bent around the sides of the housing (G).

2. A coil arrangement according to claim 1, characterised in that in each longitudinal arm a plurality of coils are located adjacent to each other, that after m coils each longitudinal arm is folded, m being a whole number, so that a plurality of coils lie behind each other.

3. A coil arrangement according to claim 1 or 2, characterised in that the conductor foil has coils printed on both sides.

## Revendications

1. Agencement de bobines pour un circuit de réglage de foyer ou de piste dans lequel les bobines (S) sont placées sur une feuille conductrice flexible en tant que circuit imprimé et sont prévues comme composants de réglage pour le circuit de réglage de foyer ou de piste, **caractérisé en ce** que la feuille conductrice est configurée en forme de H, que des bobines (S) sont imprimées dans les barres longitudinales du H, qu'un diaphragme (B), des pots à fourche et des pistes conductives sont prévus dans la barre transversale, que la barre transversale est placée sur la face supérieure ou inférieure d'un boîtier (G) en forme de parallélépipède dans lequel se trouve une lentille d'objectif (O) et que les barres longitudinales du H sont recourbées autour des côtés du boîtier (G).

2. Agencement de bobines selon la revendication 1, **caractérisé en ce** que plusieurs bobines se situent l'une à côté de l'autre dans chaque barre longitudinale, que chaque barre longitudinale est pliée respectivement après m bobines, m étant un nombre entier si bien que plusieurs bobines se trouvent l'une derrière l'autre.

3. Agencement de bobines selon la revendication 1 ou 2, **caractérisé en ce** que la feuille conductrice est imprimée des deux côtés avec des bobines.
